Europäisches Patentamt

European Patent Office

Office européen des brevets

(11) Veröffentlichungsnummer: **0 164 645**
**A2**

## (12) EUROPÄISCHE PATENTANMELDUNG

(21) Anmeldenummer: 85106575.5

(22) Anmeldetag: 29.05.85

(51) Int. Cl.⁴: **H 01 L 29/06**
**H 01 L 21/308**

(30) Priorität: **14.06.84 DE 3422051**

(43) Veröffentlichungstag der Anmeldung:
**18.12.85** Patentblatt 85/51

(84) Benannte Vertragsstaaten:
**CH DE FR GB IT LI NL**

(71) Anmelder: **BROWN, BOVERI & CIE Aktiengesellschaft**
**Kallstadter Strasse 1**
**D-6800 Mannheim 31(DE)**

(72) Erfinder: **Götzenbrucker, Oswald**
**Bockenheimer Strasse 3**
**D-6520 Worms 21(DE)**

(72) Erfinder: **Popp, Gerhard, Dr. Dipl.-Phys.**
**Schwalbenstrasse 26**
**D-6840 Lampertheim(DE)**

(74) Vertreter: **Kempe, Wolfgang, Dr. et al,**
**c/o Brown, Boveri & Cie AG Postfach 351**
**D-6800 Mannheim 1(DE)**

(54) **Silizium-Halbleiterbauelement mit ätztechnisch hergestellter Randkontur und Verfahren zur Herstellung dieses Bauelementes.**

(57) Für die erreichbare Sperrspannung bei Silizium-Halbleiterbauelementen ist die Gestaltung des Passivierungsgrabens wesentlich. Mit der Erfindung wird für ein Silizium-Halbleiterbauelement (1) eine Form eines Grabens (G) vorgeschlagen, die durch einen nahezu stetig verlaufenden Anstieg der Grabenwand im Bereich einer Flankenlange (L) zwischen einem pn-Übergang (4) und der Oberflache (0) des Silizium-Halbleiterbauelementes (1) gekennzeichnet ist. Eine solche Randkontur mit kleinem Neigungswinkel ($\alpha$) zwischen dem pn-Übergang (4) und der Grabenwand gemessen in der Mitte der Flankenlange (L) laßt sich serienmaßig mit Hilfe eines zweistufigen Atzverfahrens herstellen.

Fig 3

Croydon Printing Company Ltd.

EP 0 164 645 A2

B R O W N , B O V E R I & C I E   AKTIENGESELLSCHAFT
Mannheim                                  2. Mai 1985
Mp.-Nr. 600/84                            ZPT/P3-Sf/Bt

Silizium-Halbleiterbauelement mit ätztechnisch hergestellter Randkontur und Verfahren zur Herstellung dieses
Bauelements

Die Erfindung bezieht sich auf ein Silizium-Halbleiterbauelement nach dem Oberbegriff des Anspruchs 1 sowie
auf ein Verfahren zur Herstellung dieses Bauelements.

Silizium-Halbleiterbauelemente werden üblicherweise hergestellt, indem auf einer Siliziumscheibe mehrere Halbleiterbauelemente gleichzeitig hergestellt und später
z.B. durch Ritzen, Sägen oder mit Hilfe eines Laserstrahls getrennt werden. Durch das Trennen entsteht ein
Bauelementenrand, an dem sperrende pn-Übergangsflächen
an die Oberfläche treten und dadurch mit der das Bauelement umgebenden Atmosphäre in Kontakt kommen. Die Randgestaltung hat dabei erheblichen Einfluß auf die erzielbare Sperrspannung des Bauelements. Man strebt an, den
Rand des Bauelements so abzuschrägen, daß ein möglichst
flacher Winkel zwischen pn-Übergangsfläche und Bauelementenoberfläche resultiert, weil man dadurch niedrigere
und besser beherrschbare elektrische Feldstärken an der

Oberfläche erzielt. Eine solche gewünschte Abschragung des Randes kann man durch eine Grabenätzung erzielen.

Zur Herstellung von Bauelementen in Mesa-Technologie werden auf der Siliziumscheibe Gräben längs der Ränder der einzelnen Bauelemente eingeätzt. Die Gräben müssen tief genug sein, um die sperrenden pn-Übergänge, die üblicherweise in einer Tiefe von 60 bis 80 µm liegen, zu durchtrennen. Nach der Ätzung werden die Gräben mit einem geeigneten Passivierungsglas gefüllt, damit die pn-Übergänge abgedeckt und vor Umwelteinflüssen geschützt sind.

Weit verbreitet sind Passivierungsgräben, die längs der Trennlinien der einzelnen Bauelemente in die Scheibe eingeätzt sind.

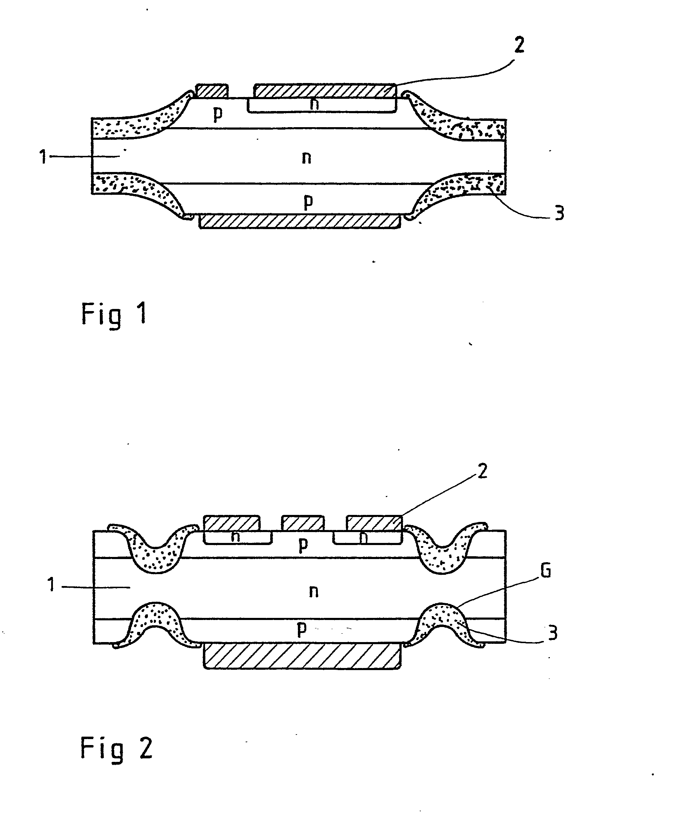

Zur Aufteilung der Scheibe in einzelne Bauelemente werden die Gräben längs ihrer Mittellinie aufgetrennt. Es entstehen somit einzelne Bauelemente, wie beispielhaft in Fig. 1 dargestellt. Fig. 1 zeigt ein bekanntes Silizium-Halbleiterbauelement 1 in Mesa-Technologie mit seinen p- und n-Schichten, einer Metallisierung 2 auf den Oberflächen und mit Passivierungsglas 3 in der Randzone.

Nachteilig bei dieser Form der Gräben ist, daß bei der Trennung der Siliziumscheibe Risse im Passivierungsglas z.B. aufgrund mechanischer Spannungen auftreten können, wodurch die erreichbare Sperrspannung herabgesetzt wird.

Eine andere bekannte Form des Passivierungsgrabens ist der sogenannte Moat, der in Fig. 2 dargestellt ist. Beim Moat ist der aktive Teil des Silizium-Bauelements 1 vom nicht benutzten Randteil oder von einem benachbarten Bauelement durch einen eigenen in sich geschlossenen Graben G getrennt, der mit Passivierungsglas 3 gefüllt ist. Auf einer Silizium-Scheibe mit mehreren Bauelementen, die später getrennt werden sollen, werden links und rechts von den vorgesehenen Trennlinien Gräben hergestellt und mit Glas gefüllt. Bei der Trennung der Scheibe in einzelne Bauelemente wird also kein Passivierungsglas, sondern lediglich Silizium durchtrennt. Nachteilig ist beim Moat mit der bekannten Randkonturierung, daß man in der Regel aus Platzgründen enge Gräben mit steiler Flanke herstellt, wodurch es zu Feldstärkeüberhöhungen kommt, die zu erheblich reduzierten Sperrspannungen führen können. Außerdem ist es bei den bis zu 100 µm tiefen Gräben wegen des großen Niveauunterschiedes schwierig, die Kanten fehlerfrei mit Passivierungsglas zu bedecken.

Aus der DE-OS 28 51 375 ist eine Gestaltung des Grabens zur Herstellung von Halbleiterbauelementen in Mesa-Technologie bekannt, die für Bauelemente bis etwa 1000 V Sperrspannung geeignet ist. Dabei wird der Graben zweistufig ausgeführt. Dazu wird zuerst ein schmaler tiefer Graben geätzt und anschließend wird in einem zweiten Ätzvorgang der Graben in einem oberen Bereich verbreitert. Der gesamte Graben wird mit einem passivierenden Glas gefüllt. Diese Anordnung hat den Zweck, Spuren der in einem späteren Prozeßschritt aufgebrachten Metallisierung, die zwischen die Glaspassivierungsschicht und die Siliziumoberfläche eindringen könnte, von der pn-Übergangsfläche fernzuhalten. Die pn-Übergangsfläche liegt nämlich im Bereich des zuerst hergestellten engen und steilen Teil des Grabens, wie auf Seite 6 der genannten Offenlegungsschrift ausgeführt wird. Es ist somit unwahrscheinlich, daß das Metallisierungsmaterial den langen Weg unter dem Glas im flachen Teil des Grabens hindurch bis zum steilen Teil des Grabens zurücklegt. Allerdings hat diese Anordnung bezüglich der Sperrspannungsfestigkeit die gleichen Nachteile, die oben z.B. für den üblichen Moat mit einem pn-Übergang in einem steilen Teil des Grabens genannt wurden.

In dem Aufsatz "The Theory and Application of a Simple Etch Contour for Near Ideal Breakdown Voltage in Plane and Planar p- Junctions" von V.A.K. Temple und M.S. Adler in IEEE Transactions on Electron Devices, Vol. ED-23, No., 8, August 1976, Seite 950 bis 955 und in dem Aufsatz "Practical Aspects of the Depletion Etch Method in High-Voltage Devices" von V.A.K. Temple in IEEE Transactions on Electron Devices, Vol. ED-27, No. 5, May 1980, Seite 977 bis 982 ist eine Randkontur angegeben, bei der die Raumladungszone in der diffundierten Schicht im wesentlichen parallel zur pn-Übergangsfläche angeätzt wird. Eine solche Randkontur ist für hohe Sperrspannungen geeignet. Die erreichbaren Sperrspannungen entsprechen fast den Volumendurchbruchsspannungen. Allerdings muß man die dafür optimale Ätztiefe sehr genau erreichen. Schon eine geringe Abweichung von der optimalen Ätztiefe führt zu einem drastischen Abfall der Sperrspannung. Es leuchtet ein, daß ein solches Verfahren bzw. eine solche Randkontur nicht für eine Serienfertigung geeignet ist. Das Verfahren ist in den genannten Druckschriften auch nur für die Herstellung von Einzelelementen beschrieben. Es eignet sich nicht für den praktischen Fall, in dem mehrere Chips auf einer Siliziumscheibe gemeinsam geätzt werden sollen, wie es z.B. bei der Herstellung von glaspassivierten Bauelementen üblich ist. Man könnte die erforderlichen engen Ätztoleranzen nicht einhalten.

Aus der FR-OS 24 68 207 ist ein Silizium-Halbleiterbauelement mit einem scheibenförmigen Silizium-Halbleiterkörper mit ätztechnisch hergestellter Randkontur bekannt, bei dem die Randkontur im Bereich einer Flankenlänge zwischen dem Austritt eines zwischen einem stärker dotierten p-Gebiet und einem schwächer dotierten n-Gebiet verlaufenden pn-Übergangs in einem Passivierungsgraben und der den Passivierungsgraben aufweisenden Hauptflache des Halbleiterkörpers einen kleinen Neigungswinkel von unter 10° bzw. unter 6° aufweist. Dabei wird in dieser Druckschrift jeweils von einer ersten Leitfähigkeit (p oder n) und einer zweiten Leitfähigkeit (n oder p) gesprochen, was bedeutet, daß die Leitfähigkeiten vertauscht sein können. Das Gleiche gilt selbstverständlich auch für die vorliegende Erfindung, in der zur einfacheren Beschreibung von einer gewahlten Folge der Leitfahigkeiten ausgegangen wird. Bei der Herstellung der Gräben kommt man nach der FR-OS 24 68 207 nicht ohne mechanische Bearbeitungsschritte (Schleifen, Sandstrahlen) aus. Nach dem mechanischen Bearbeitungsschritt, der die Grabenkontur im wesentlichen bereits festlegt, erfolgt ein chemisches Uberätzen, um mechanische Damage-Schichten zu entfernen. Die Randkontur wird dabei nicht mehr stark verändert. Die mechanische Herstellung der Randkontur - insbesondere von Moat-Gräben - ist sehr aufwendig.

Der Erfindung liegt die Aufgabe zugrunde, ein Silizium-Halbleiterbauelement mit ätztechnisch hergestellter Randkontur für hohe Sperrspannungen und ein Verfahren zur Herstellung eines solchen Bauelements anzugeben, wobei die oben genannten Nachteile vermieden werden.

Diese Aufgabe wird durch ein Silizium-Halbleiterbauelement nach dem Anspruch 1 und durch Herstellverfahren nach den Ansprüchen 3 bis 5 gelöst.

Nach dem erfindungsgemäßen Vorschlag können Halbleiterbauelemente mit Sperrspannungen von mindestens 1600 V hergestellt werden. Es werden keine hohen Anforderungen an die einzuhaltenden Toleranzen für die Geometrie des Grabens gestellt. Die ätztechnische Herstellung in einer Serienfertigung ist deshalb möglich. Vorteilhaft ist auch, daß die pn-Übergänge ausreichend weit von den Grabenkanten weg ins Innere der Gräben verlegt sind, so daß auch bei Verglasungsfehlern (bei Glaspassivierung) an den Kanten die Abdeckung der pn-Übergänge nicht beeinträchtigt ist. Jedoch ist nicht mit Verglasungsfehlern zu rechnen, da an den Grabenkanten die Stufenhöhe auf etwa die Hälfte verringert ist und relativ stumpfe Winkel auftreten, deren Abdeckung problemlos ist. Anstelle von Glaspassivierung können auch andere Passivierungsarten vorgesehen sein.

Weitere Vorteile ergeben sich aus den Ausführungsbeispielen, die anhand der Zeichnung beschrieben werden.

Es zeigen:

Fig. 1    Halbleiterbauelement im Querschnitt nach dem Stand der Technik in Mesa-Technologie,

Fig. 2    Halbleiterbauelement im Querschnitt nach dem Stand der Technik in Mesa-Technologie mit einem Passivierungsgraben nach Art eines Moats,

Fig. 3    Halbleiterbauelement im Querschnitt mit einer erfindungsgemäßen Randkontur. In der Draufsicht kann das Bauelement beliebigg geformt sein (z.B. rund oder rechteckig.)

Fig. 4    Darstellung gemessener Sperrspannungen an einem erfindungsgemäßen Silizium-Halbleiterbauelement,

Fig. 5    Halbleiterbauelement mit einer ersten Ätzmaske zur Herstellung eines Passivierungsgrabens nach einem ersten Herstellungsverfahren,

Fig. 6    Halbleiterbauelement mit einer zweiten Ätzmaske zur Herstellung eines Passivierungsgrabens nach einem ersten Herstellungsverfahren,

Fig. 7    Halbleiterbauelement mit einer ersten Ätzmaske
         zur Herstellung eines Passivierungsgrabens
         nach einem zweiten Herstellungsverfahren,
Fig. 8    Halbleiterbauelement mit einer zweiten Ätzmaske zur Herstellung eines Passivierungsgrabens
         nach einem zweiten Herstellungsverfahren.

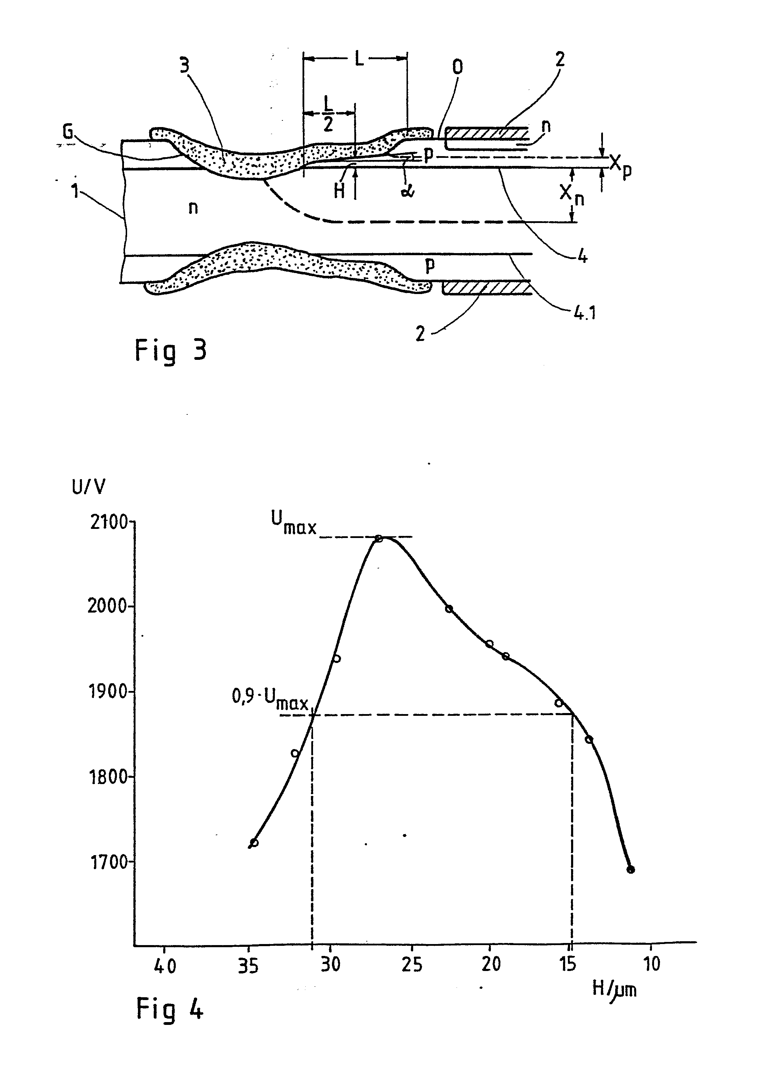

Fig. 3 zeigt die Randzone eines als Moat ausgeführten erfindungsgemäßen Silizium-Halbleiterbauelements 1 mit einer Metallisierung 2 auf seiner Oberfläche O. Die Randzone weist auf der Ober- und Unterseite des Silizium-Halbleiterbauelements 1 einen Graben G auf, der mit Passivierungsglas 3 gefüllt ist. Das Passivierungsglas 3 reicht etwas über den Grabenrand hinaus, um die Isolationsstrecke zu verlangern. Der Graben G durchtrennt einen pn-Ubergang 4 und reicht bis in ein n-leitendes Gebiet hinein. Mit gestrichelter Linie ist eine erste Ausdehnung $x_p$ der Raumladungszone eingetragen, wobei es sich um die Ausdehnung $x_p$ der Raumladungszone vom pn-Ubergang 4 in ein p-leitendes Gebiet handelt. Ebenfalls mit gestrichelter Linie ist eine zweite Ausdehnung $x_n$ der Raumladungszone vom pn-Ubergang 4 in das n-leitende Gebiet eingetragen. Die Ausdehnungen $x_n$, $x_p$ der Raumladungszone stellen sich bei Anliegen der Abbruchspannung am pn-Ubergang 4 des Silizium-Halbleiterbauelements 1 ein.

Wesentlich ist die Gestaltung des Grabens G. Aus Platzgründen ist der Graben G asymmetrisch ausgeführt mit einem flacheren Anstieg auf der dem aktiven Teil des Silizium-Halbleiterbauelements 1 zugewandten Seite. In Fig. 3 ist der aktive Teil des Silizium-Halbleiterbauelements 1 auf der rechten Seite dargestellt.

Für die Höhe der erreichbaren Sperrspannung ist die Ausführung der Grabenkontur im Bereich einer Flankenlänge L maßgebend. Die Flankenlänge L gibt den Abschnitt des Grabens G im Bereich zwischen dem pn-Übergang 4 und der Oberfläche O des Silizium-Halbleiterbauelements 1 an. Sie wird bemessen nach der

Gleichung       (1):    $L = (0,8...1,6) \cdot x_n$

Die Höhe H der Siliziumschicht über dem pn-Übergang 4, gemessen bei der Hälfte der Flankenlänge L, wird bemessen nach

Gleichung       (2):    $H = (0,5...1,2) \cdot x_p$

Bei der Hälfte der Flankenlänge L wird auch ein Neigungswinkel $\alpha$ gemessen, der die Neigung der Flanke (Grabenwand) gegenüber dem pn-Übergang 4 angibt.

Der Boden des Grabens G nimmt im Bereich der Flankenlänge L einen nahezu stetig schrägen Verlauf. Darin liegt ein wesentlicher Unterschied zu dem aus den bereits genannten Aufsätzen von Temple und Adler bekannten Vorschlag, bei dem ein im wesentlichen zum pn-Übergang 4 paralleler Verlauf der Flanke vorgesehen ist. Dies ist von erheblicher praktischer Bedeutung, da die Toleranz, mit der die Höhe H eingestellt wird, bei schrägem Verlauf der Flanke wesentlich größer sein kann, als bei flachem Verlauf. Hierzu sind in Fig. 4 an erfindungsgemäßen Silizium-Halbleiterbauelementen 1 gemessene Sperrspannungen U dargestellt, in Abhängigkeit von der durch unterschiedlich tiefes Ätzen, d.h. durch unterschiedliche Ätzdauer eingestellte Höhe H über dem pn-Übergang 4. Die gemessene maximale Sperrspannung $U_{max}$ (= Abbruchspannung) entspricht nahezu der Volumendurchbruchspannung des Bauelementes. Der Fig. 4 ist zu entnehmen, daß bei einer Toleranz von 16 µm für die Einstellung mit der Höhe H über dem pn-Übergang 4 minde

stens 90% der Maximalspannung erreicht wird. Dagegen errechnet man für ein Diffusionsprofil gleicher Art nach dem Stand der Technik (oben angegebene Aufsätze von Temple und Adler) lediglich einen Toleranzwert von 4 µm für die Einhaltung der Höhe H. Ein solcher enger Toleranzbereich ist in der praktischen Fertigung nicht einzuhalten.

Die Herstellung eines Grabens G mit der in Fig. 3 dargestellten und durch die Gleichungen (1) und (2) beschriebenen Form kann auf unterschiedliche Weise erfolgen.

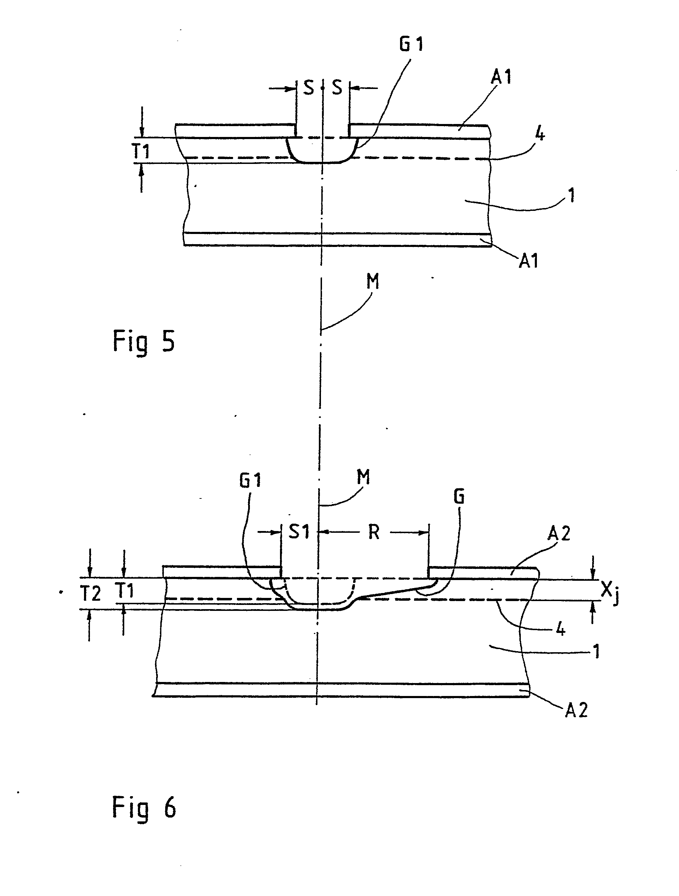

Für Gräben G mit einer Flankenlänge L von etwa 110 bis 220 µm (entspricht Bauelementen mit etwa 1600 V Sperrspannung) ist vorzugsweise ein erstes Herstellverfahren geeignet, das in den Fig. 5 und 6 dargestellt ist. Man erreicht damit einen Neigungswinkel $\alpha$ von etwa 1 bis 3°. Das erste Herstellverfahren wird nachstehend anhand der Fig. 5 und 6 beschrieben. Fig. 5 zeigt ein Silizium-Halbleiterbauelement 1 mit einem pn-Übergang 4. Der aktive Teil des Silizium-Halbleiterbauelements 1 liegt bei den Darstellungen der Fig. 5 bis 8 jeweils auf der rechten Seite. Außerdem sind bei den Fig. 5 bis 8 die Maßangaben für die Maskierung auf eine Bezugsfläche M bezogen, wobei die Bezugsfläche M durch die Mitte eines schmalen Grabens G1, G3 geht, der bei dem ersten Herstellverfahren zuerst hergestellt wird. Dazu wird in einem ersten Verfahrensschritt eine erste Ätzmaske A1 auf das Silizium-Halbleiterbauelement 1 aufgebracht. An der Stelle, an der der schmale Graben G1 geätzt werden soll, hat die Maske A1 eine Öffnung, wobei die Kanten der Maske A1 links und rechts von der Bezugsfläche M einen kleinen Abstand S haben.

In einem zweiten Verfahrensschritt wird der schmale Graben G1 bis zu einer ersten Tiefe T1 geätzt, die knapp über den pn-Übergang 4 hinausgeht. Danach wird in einem dritten Verfahrensschritt die Ätzmaske A1 entfernt.

Im vierten Verfahrensschritt wird eine zweite Ätzmaske A2 auf das Silizium-Halbleiterbauelement 1 aufgebracht, wie in Fig. 6 dargestellt. Die Öffnung der Ätzmaske A2 im Bereich des Grabens G1 wird asymmetrisch zur Bezugsfläche M ausgeführt. Der Abstand S1 der Kante der Ätzmaske A2 auf der Seite links von der Bezugsfläche M ist unkritisch, da es sich bei dem linken Teil des Silizium-Halbleiterbauelements 1 um den inaktiven Randbereich handelt. Dieser Abstand S1 entspricht etwa der halben Breite des schmalen Grabens G1.

Wesentlich ist der in Fig. 6 dargestellte große Abstand R des rechten Maskenrandes von der Bezugsfläche M, weil damit die Grabenform im aktiven Teil des Silizium-Halbleiterbauelements 1 bestimmt wird. Die erwünschte Grabenform mit der Flankenlänge L stellt sich ein, wenn der kleine Abstand S der beiden Kanten der ersten Ätzmaske A1 von der Bezugsfläche M und der große Abstand R der rechten Kante der zweiten Ätzmaske A2 von der Bezugsfläche M der nachstehenden Beziehung genügt:
Gleichung    (3):   $R - S = L + x_j/2$

Darin bedeutet $x_j$ die in Fig. 6 eingetragene Tiefe des pn-Übergangs 4.

Im fünften Verfahrensschritt erfolgt die Ätzung des gewünschten Grabens G. Die Ätzzeit wird so bemessen, daß sich die durch Gleichung (2) definierte Höhe H einstellt. Der ursprüngliche schmale Graben G1 wird dabei etwas tiefer bis zu einer zweiten Tiefe T2 geätzt und auf der rechten Grabenseite stellt sich die gewünschte schräge Flanke ein. Im sechsten Verfahrensschritt wird schließlich die Ätzmaske A2 entfernt.

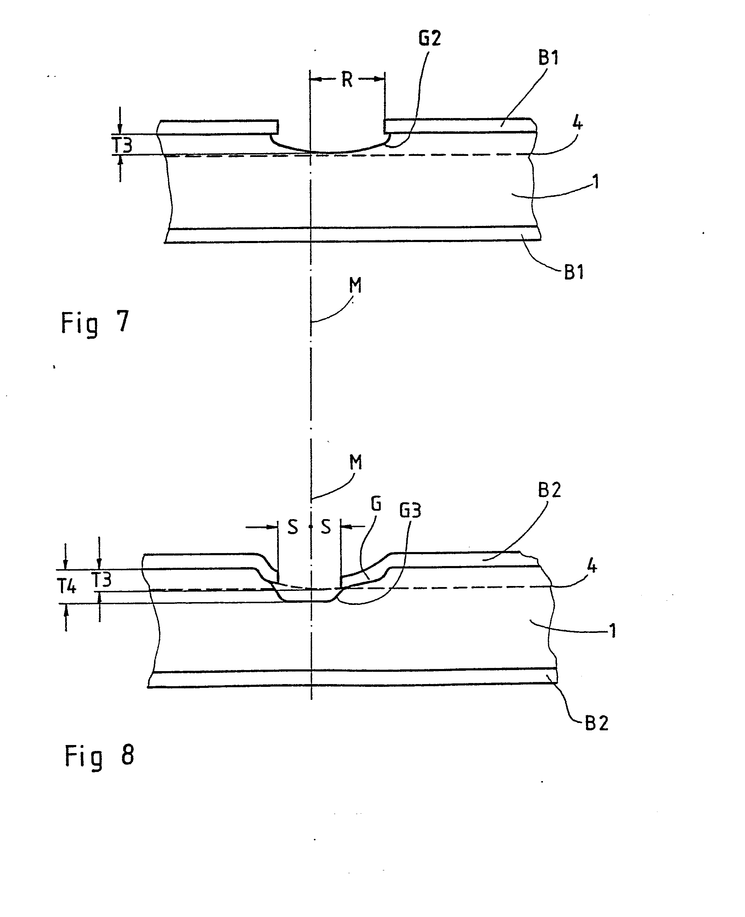

Die erfindungsgemäße Grabenform kann auch nach einem zweiten Herstellverfahren hergestellt werden, das nachstehend anhand der Fig. 7 und 8 beschrieben wird. Dieses zweite Verfahren ist besonders geeignet zur Herstellung eines Grabens G mit der Flankenlänge L = 55 bis 110 µm für Silizium-Halbleiterbauelemente 1 mit einer Sperrspannung bis etwa 800 V. Der in Fig. 3 eingetragene Neigungswinkel $\alpha$ beträgt hierbei etwa 3 bis 7$^{\circ}$.

In Fig. 7 ist ein Silizium-Halbleiterbauelement 1 mit einem pn-Übergang 4 und einer ersten Ätzmaske B1 dargestellt, die in einem ersten Verfahrensschritt aufgebracht wird. Die Maskenöffnung zur Herstellung eines breiten Grabens G2 wird asymmetrisch zu der Bezugsfläche M gelegt, die durch die Mitte eines in einem späteren Verfahrensschritt herzustellenden kleinen Grabens G3 (Fig. 8) geht. Der Maskenrand auf der rechten Seite von der Bezugsfläche M, also auf der aktiven Seite des Silizium-Halbleiterbauelements 1, hat einen großen Abstand R. Die Beziehung zwischen dem großen Abstand R für die erste Ätzmaske B1 und dem kleinen Abstand S für die in einem späteren Verfahrensschritt aufzubringende Ätzmaske B2 (Fig. 8) zur angestrebten Flankenlänge L ist angegeben in
Gleichung   (4):   R - S = L

Im zweiten Verfahrensschritt erfolgt eine Ätzung zur Herstellung des breiten Grabens G2 bis zu einer ersten Tiefe T3 knapp oberhalb des pn-Übergangs 4. Anschließend wird im dritten Verfahrensschritt die Maske B1 entfernt.

Im vierten Verfahrensschritt wird eine zweite Ätzmaske B2 aufgebracht, wie in Fig. 8 dargestellt. Die Maske B2 bedeckt den bereits fertigen Teil des Grabens G und hat eine Öffnung mit einem linken und einem rechten kleinen Abstand S von der Bezugsfläche M. Im fünften Verfahrensschritt wird der kleine Graben G3 geätzt bis zu einer zweiten Tiefe T4, die über den pn-Übergang 4 hinausgeht. Dabei entsteht die gewünschte Form des Grabens G. Im sechsten Schritt wird die zweite Ätzmaske B2 entfernt.

Würde man für Bauelemente, die eine Flankenlänge L von 55 bis 110 µm erfordern, das erste Verfahren anwenden, so würde der sich ergebende Winkel $\alpha$ größer als 3 bis 7° sein. Deshalb ist für solche Bauelemente das zweite Verfahren vorzuziehen; es liefert in diesem Bereich der Flankenlänge L kleinere Winkel $\alpha$ als das erste Verfahren.

Außer den oben beschriebenen Herstellverfahren, bei denen zwei Ätzmasken nacheinander verwendet werden, sind noch andere Herstellverfahren möglich. Es kann z.B. mit einer einzigen Ätzmaske gearbeitet werden, wenn aufeinanderfolgend unterschiedliche Ätzgemische benutzt werden. Dabei wird zuerst ein Ätzgemisch mit möglichst dotierungsunabhängiger Ätzgeschwindigkeit und danach ein Ätzgemisch mit stark dotierungsabhängiger Ätzgeschwindigkeit verwendet. Mit dem letzten Ätzgemisch sollen vor allem die hochdotierten Gebiete angegriffen werden. Mit dem ersten Ätzgemisch wird ein Graben einheitlicher Tiefe hergestellt, der mit Hilfe des zweiten Ätzgemisches hauptsächlich im hochdotierten Gebiet verbreitert wird.

<u>A n s p r ü c h e</u>

1. Silizium-Halbleiterbauelement mit einem scheibenförmigen Silizium-Halbleiterkörper mit ätztechnisch hergestellter Randkontur, der ein zu einer Hauptfläche des Halbleiterkörpers paralleles p-Gebiet und in dieser Hauptfläche einen Passivierungsgraben aufweist, in den ein zwischen dem stärker dotierten p-Gebiet und einem schwächer dotierten n-Gebiet verlaufender pn-Ubergang mündet, bei dem die Randkontur im Bereich einer Flankenlänge zwischen dem Austritt des pn-Ubergangs in den Passivierungsgraben und dieser Hauptfläche des Halbleiterkörpers einen kleinen Neigungswinkel von 1 bis 7° aufweist, <u>dadurch gekennzeichnet,</u> daß der Neigungswinkel ($\alpha$) der Randkontur über den größten Teil der Flankenlänge (L) nahezu gleichmäßig ist und daß die nachstehenden Beziehungen gelten:

$L = (0,8...1,6) \cdot x_n$ und

$H = (0,5...1,2) \cdot x_p,$

worin bedeuten:

$H$ = Höhe der p-dotierten Siliziumschicht über dem pn-Ubergang (4), gemessen in der Mitte der Flankenlänge (L),

$x_n$ = Ausdehnung der Raumladungszone in das n-Gebiet,

$x_p$ = Ausdehnung der Raumladungszone in das p-Gebiet bei der Abbruchspannung des Bauelementes.

2. Silizium-Halbleiterbauelement nach Anspruch 1, dadurch gekennzeichnet, daß sein Passivierungsgraben (G) als Moat hergestellt ist.

3. Verfahren zur Herstellung eines Silizium-Halbleiterbauelements nach Anspruch 1 oder 2 in zwei Ätzschritten, gekennzeichnet durch nachstehende Verfahrensschritte zur Herstellung des Passivierungsgrabens (G):

a) Aufbringen einer ersten Ätzmaske (A1) auf die Hauptfläche (O) des Silizium-Halbleiterbauelements (1), wobei die Ätzmaske (A1) im Bereich eines herzustellenden schmalen Grabens (G1) eine Öffnung mit einem kleinen Abstand (S) der Kanten der Ätzmaske (A1) von einer durch die Mitte des Grabens (G1) gehenden Bezugsfläche (M) aufweist,

b) Ätzen des schmalen Grabens (G1) bis zu einer ersten Tiefe (T1), die knapp über den pn-Übergang (4) hinausgeht,

c) Entfernen der ersten Ätzmaske (A1),

d) Aufbringen einer zweiten Ätzmaske (A2) auf die Hauptfläche (O) des Silizium-Halbleiterbauelements (1), wobei eine Öffnung der Ätzmaske (A2) im Bereich des Grabens (G1) asymmetrisch zur Bezugsfläche (M) ausgeführt wird, indem die Ätzmaske (A2) auf der Seite des nicht benutzten Randbereiches des Silizium-Halbleiterbauelements (1) etwa mit der Kante des Grabens (G1) abschließt und auf der Seite des aktiven Teils des Silizium-Halbleiterbauelements (1) mit einem großen Abstand (R) von der Bezugsfläche (M) abschließt und wobei der große Abstand (R) im Verhältnis zum kleinen Abstand (S) der ersten Ätzmaske (A1) nach der Gleichung

$$R - S = L + x_j/2$$

gewählt wird, worin $x_j$ die Tiefe des pn-Übergangs (4) bedeutet,

e)   Ätzen des Grabens (G) bis der Graben (G) im Bereich des zuvor hergestellten schmalen Grabens (G1) etwas weiter bis zu einer zweiten Tiefe (T2) geätzt ist und sich auf der Seite des aktiven Teils des Silizium-Halbleiterbauelements (1) ein flacher Anstieg des Grabens (G) im Bereich der Flankenlänge (L) mit einem Neigungswinkel ( $\alpha$ ) von etwa 3 bis 7° und einer Höhe (H) einstellt,

f)   Entfernen der zweiten Ätzmaske (A2).

4. Verfahren zur Herstellung eines Silizium-Halbleiterbauelements nach einem der Ansprüche 1 bis 2 in zwei Ätzschritten, gekennzeichnet durch nachstehende Verfahrensschritte zur Herstellung des Passivierungsgrabens (G):

a)   Aufbringen einer ersten Ätzmaske (B1) auf die Hauptfläche (O) des Silizium-Halbleiterbauelements (1) zur Herstellung eines breiten Grabens (G2), wobei die Öffnung der Ätzmaske (B1) asymmetrisch zu einer Bezugsfläche (M) ausgeführt wird, die durch die Mitte eines anschließend herzustellenden kleinen Grabens (G3) geht und wobei auf der dem aktiven Teil des Silizium-Halbleiterbauelements (1) zugewandten Seite ein großer Abstand (R) der Kante der Ätzmaske (B1) von der Bezugsfläche (M) gewählt wird, wobei der große Abstand (R) der Summe aus der herzustellenden Flankenlänge (L) und einem kleinen Abstand (S) einer später zur Herstellung des kleinen Grabens (G3) aufzubringenden zweiten Ätzmaske (B2) von der Bezugsfläche (M) entspricht,

b)   Ätzen des breiten Grabens (G2) bis zu einer ersten Tiefe (T3) knapp oberhalb des pn-Übergangs (4), wobei die Höhe (H) in der Mitte der Flankenlange (L) einzustellen ist,

c)   Entfernen der ersten Ätzmaske (B1),

d) Aufbringen einer zweiten Ätzmaske (B2) auf die
Hauptfläche (O) des Silizium-Halbleiterbauelements
(1) mit einer Öffnung der Ätzmaske (B2) im Bereich
der Bezugsfläche (M) mit einem beidseitigen kleinen
Abstand (S) der Kanten der Ätzmaske (B2)

e) Ätzen des kleinen Grabens (G3) bis zu einer zweiten
Tiefe (T4), die über den pn-Übergang (4) hinausgeht,

f) Entfernen der zweiten Ätzmaske (B2).


5. Verfahren zur Herstellung eines Silizium-Halbleiterbauelements nach einem der Ansprüche 1 bis 2 in
zwei Ätzschritten, gekennzeichnet durch nachstehende
Verfahrensschritte zur Herstellung des Passivierungsgrabens (G):

a) Aufbringen einer Ätzmaske auf die Hauptfläche (O)
des Silizium-Halbleiterbauelements (1) mit einer
Öffnung in der Ätzmaske im Bereich des herzustellenden Grabens (G), wobei die Breite der Öffnung
nahezu dem tiefen Teil des herzustellenden Grabens
(G) entspricht,

b) erste Ätzung mit einem Ätzgemisch, das eine weitgehend dotierungsunabhängige Ätzgeschwindigkeit
aufweist,

c) zweite Ätzung mit einem Ätzgemisch, das eine weitgehende dotierungsabhängige Ätzgeschwindigkeit aufweist, derart, daß vor allem die hochdotierten Gebiete angegriffen werden und der Graben im oberen
Teil verbreitert wird.

Fig 1

Fig 2

0164645

Fig 3

Fig 4

Fig 5

Fig 6

0164645

Fig 7

Fig 8